# EUROPEAN PATENT SPECIFICATION

(11) **EP 2 343 746 B1**
(45) Date of publication and mention of the grant of the patent: **24.10.2012**
(21) Application number: 10150453.8
(22) Date of filing: 11.01.2010
(51) Int. Cl.: H01L 41/053, F02M 51/06

(54) **Method of Encapsulating an Actuator having a Piezoelectric Actuator Stack**
Verfahren zur Verkapselung eines Aktuators mit einem piezoelektrischen Aktuatorstapel
Procédé d'encapsulation d'un actionneur doté d'un empilement d'actionneur piézoélectrique

(43) Date of publication of application: 13.07.2011
(73) Proprietor: Delphi Technologies Holding S.à.r.l., 4940 Bascharage (LU)
(72) Inventor: Berlemont, Jean-Francois, B-1860, MEISE (BE); Gris, Christian, 41350, SAINT-CLAUDE-DE-DIRAY (FR); Winandy, Jean-Pierre, 6700, ARLON (BE); Vit, Romain, 57000, METZ (FR)
(74) Representative: Gregory, John David Charles

(56) References cited:
- EP-A2- 1 939 950
- WO-A2-2007/093921
- DE-A1-102008 001 524

## Description

### Technical field

The present invention relates to a method of assembling a fuel injector for use in a fuel system of an internal combustion engine, particularly a fuel system of the accumulator or common rail type, the fuel injector being of the type controlled using a piezoelectric actuator.

### Background Art

It is known to use piezoelectric actuators in fuel injectors of internal combustion engines. Such piezoelectrically operable fuel injectors provide a high degree of control over the timing of injection events within the combustion cycle and the volume of fuel that is delivered during each injection event. This permits improved control over the combustion process, which is essential in order to keep pace with increasingly stringent worldwide environmental regulations. Such fuel injectors may be employed in compression ignition (diesel) engines or spark ignition (petrol) engines.

A typical piezoelectric actuator unit designed for use in an automotive fuel injector has a stack structure formed from an alternating sequence of piezoelectric elements or layers and planar internal electrodes. The piezoelectric layers, in turn, form an alternating sequence of oppositely polarised layers, and the internal electrodes form an alternating sequence of positive and negative internal electrodes. The positive internal electrodes are in electrical connection with a first external electrode, hereinafter referred to as the positive side electrode. Likewise, the internal electrodes of the negative group are in electrical connection with a second external electrode, hereinafter referred to as the negative side electrode.

If a voltage is applied between the two external electrodes, the resulting electric fields between each adjacent pair of positive and negative internal electrodes cause each piezoelectric layer, and therefore the piezoelectric stack, to undergo a strain along its length, i.e. along an axis normal to the plane of each internal electrode. Because of the polarisation of the piezoelectric layers, it follows that not only can the magnitude of the strain be controlled by adjusting the applied voltage, but also the direction of the strain can be reversed by switching the polarity of the applied voltage. Rapidly varying the magnitude and/or polarity of the applied voltage causes rapid changes in the strength and/or direction of the electric fields across the piezoelectric layers, and consequentially rapid variations in the length of the piezoelectric actuator. Typically, the piezoelectric layers of the stack are formed from a ferroelectric material such as lead zirconate titanate (PZT).

Such an actuator is suitable for use in a fuel injector, for example of the type known from the present Applicant's European Patent No. EP 0995901 B. The fuel injector is arranged so that a change in length of the actuator results in a movement of a valve needle. The needle can be thus raised from or lowered onto a valve seat by control of the actuator length so as to permit a quantity of fuel to pass through drillings provided in the valve seat.

In use, the actuator of such a fuel injector is surrounded by fuel at high pressure. The fuel pressure may be up to or above 2000 bar. In order to protect the piezoelectric actuator from damage and potential failure, the piezoelectric actuator must be isolated from this environment by at least a layer of barrier material, herein referred to as 'encapsulation member'. It is known to encapsulate the piezoelectric actuator with an inert fluoropolymer, for example as described in the Applicant's European published Patent Application No. EP 1356529 A, which acts to prevent permeation of liquid fuel, water and contaminant substances dissolved in the water or fuel, into the structure of the actuator. To be successful as a means of encapsulating the piezoelectric actuator, the encapsulation means must also be able to withstand fuel and water permeation over the entire operational temperature range of between around -40°C and around 175°C during the lifetime of the fuel injector which is about 10 years.

A piezoelectric actuator suitable for use in an automotive fuel injector, comprising a device body bearing encapsulation member to protectively encapsulate the device body wherein the encapsulation member includes several organic layers and at least one metal layer is known from the Applicant's published PCT Patent Application No. WO2007093921 A.

It has been found that the known encapsulations based a.o. on fluoropolymers are not completely impermeable to liquids such as diesel fuel, rapeseed methyl ester (RME) based fuels and water and that further efforts are needed to ensure a better encapsulation at reasonable costs. It is indeed often a matter of time and temperature, as to when fuel or other liquids will permeate through the encapsulation means leading to fatal component failure of the piezoelectric actuator and, thus, the fuel injector as a whole.

Against this background, it would be desirable to provide an improved encapsulating method, which provides a reduced permeability to fuel, water and other substances therein over time.

### Summary of the Invention

This object is achieved by a method of encapsulating an actuator having a piezoelectric actuator stack and electrical connector means, wherein the stack is encapsulated in an encapsulation member, said encapsulation member comprising at least an innermost heat shrinkable, polymeric sleeve member and an overlaying outermost, heat shrinkable, polymeric sleeve member, the sleeve members having each a different shrinkage temperature, wherein the shrinkage temperature of the outermost sleeve member is higher than the shrinkage temperature of the innermost sleeve member, said method comprising the following steps:
a. arranging the stack inside the innermost sleeve member,
b. arranging the outermost sleeve member so as to overlay the innermost sleeve member,
c. placing the stack under vacuum so as to degas it,
d. heating the stack above the shrinkage temperature of the outermost sleeve member so as to shrink the outermost sleeve member,
e. placing the stack under atmospheric pressure,
f. cooling the actuator.

A major advantage of the method according to the invention is to provide a piezoelectric actuator stack which has an improved fuel seal over time.

The fact that the encapsulating means comprises at least two layers of heat shrinkable materials having different shrinkage temperatures and the fact that the stack is heated under vacuum and that the shrinkage takes place under vacuum and that the stack is cooled to ambient temperature only after the pressure has been re-established not only greatly enhances the fuel sealing properties but makes it possible to improve the resistance to electrical failure resulting from cracks in the piezoelectric stack. The encapsulation method according to the invention thus provides reduced permeability to fuel, water and other substances therein over time.

Heat shrinkable sleeves or tubing, commonly called "heat shrink" or "shrink tubing" are well known and are mainly used to bundle, electrically insulate, and protect wires, electrical components and other objects.

The original inside diameter of the sleeves is selected large enough to slip over the component to be covered, and the sleeves can subsequently be shrunk onto the stack by heating the sleeve using a source of thermal energy.

A large number of polymers are currently available to produce heat shrinkable sleeves :
- PTFE (fluoropolymer) tubes have the widest operating temperature range (-270 to 260 °C), low coefficient of friction, and high resistance to chemicals. 1.5:1, 2:1 and 4:1 shrink ratios are available on the market.
- Viton, another fluoropolymer with high chemical resistance and highly flexible. Viton is a brand of synthetic rubber and fluoropolymer elastomer commonly used in moulded or extruded goods. The name is a registered trademark of DuPont Performance Elastomers L.L.C.. Viton fluoroelastomers are categorized under the ASTM D1418 & ISO 1629 designation of FKM. This class of elastomers is a family comprising copolymers of hexafluoropropylene (HFP) and vinylidene fluoride (VDF or VF2), terpolymers of tetrafluoroethylene (TFE), vinylidene fluoride (VDF) and hexafluoropropylene (HFP) as well as perfluoromethylvinylether (PMVE) containing specialties.

- Polyvinylidene fluoride (PVDF) tubes are intended for high temperature applications; -55 °C up to 150 °C (flexible PVDF) or up to 175 °C (semi-rigid Kynar). Common shrink ratio is 2:1, and shrink temperature ranges around 170°C.
- Fluorinated ethylene propylene (FEP) is a lower-cost alternative to PTFE. Its operating temperature range is up to 204 °C and the shrink temperature is as low as 190 °C. Available shrink ratios are 3:1 and 6:1.
- Silicone rubber offers excellent resistance to scrape abrasion and high flexibility. The shrink temperature is 200 °C

Particularly preferred in the context of the present invention are the following thermoplastic polymers for heat shrinkable sleeves: ethylene tetrafluoroethylene (ETFE), a polytetrafluoroethylene (PTFE) thermoplastic, a polyvinyldifluoride (PVDF), a fluorinated ethylene-propylene (FEP), a perfluoroalkoxy (PFA) or a polytetrafluoroethylene-perfluoromethylvinylether (MFA) and polymers of tetrafluoroethylene, hexafluoropropylene and vinylidene fluoride (THV).

A second aspect of the invention provides a method as discussed above, which further comprises the following step between steps a and b:
a1) heating the stack above the shrinkage temperature of the innermost sleeve member so as to shrink said innermost sleeve member.

This "double shrinkage" allows to obtain a particularly tight fit of the encapsulation with regard to the stack.

Another aspect of the invention provides a method as discussed above wherein the sleeve members have a different melting temperature, the shrinkage temperature of the outermost sleeve member is higher than the melting temperature of the innermost sleeve member and wherein the innermost sleeve member is melted during step c.

The method may according to a preferred embodiment further comprise arranging the stack inside one or more further, additional sleeve members between step a and b. These sleeve members may be made of different materials which present particular properties like f.ex. an improved impermeability with regard to one or more specific components of fuel.

The method may further comprise wrapping a metallic film around the innermost sleeve member between step a and b. A metallic layer may also be applied between organic inner layers as described for example in the International Publication No WO 2007/093921 A2.

The material of the innermost sleeve members may be chemically or physically modified in order to bond to the substrate or surface of the stack, to facilitate bonding to the stack or to the outermost sleeve member and/or to the optional metallic film.

The method may further comprise end sealing the actuator. A suitable end sealing may be achieved by mechanically compressing the polymer of the encapsulation by a clamping force, by placing (or not) a fuel resistant sealant between the substrate and the polymer and by shaping the substrate in order to improve sealing properties, as described for example in patent applications EP 1 783 842 A, WO 2007/128948 A, EP 1 978 242 A, EP 2 014 966 A or EP 2 086 028 A.

Although it may not be required, the piezoelectric actuator stack may be passivated before encapsulation.

The idea of the above discussed embodiments is to use the outermost (external) heat shrinkable sleeve as container for the re-melted material of the innermost sleeve member and the optional further sleeve(s) in a multi layer arrangement. The melting of the organic innermost sleeve(s) is obtained during the shrinkage of the outermost (external) layer under vacuum. By melting the materials of the inner sleeve members, an excellent adhesion may be reached between the layers themselves and if applicable, the metallic film, which will enhance the permeation property of the whole encapsulation. The mechanical stability of the encapsulation is also increased.

The method may further comprise mechanically compressing the encapsulation member to shape it so as to obtain a better fit with the injector.

The advantages of the resulting stack with a re-melted multilayer encapsulation is multiple:
- Better protection of the actuator from the environment (fuel at high pressure):
   Material of each barrier may be chosen and adapted in view of protecting against specific component of fuel or additives.
- Embedding the electrical bridge of the actuator making it thus more robust and reducing the risk of cracks.
- Smoothing the geometry of the actuator and decrease the stress induced into the encapsulation due to too sharp geometrical transitions.
- Avoid pumping effect of fuel inside the encapsulation means due to lack of free space inside the encapsulation means..
- The passivation of the piezo stack can be replaced by the most inside polymeric layer and therefore will avoid carrying conductive material in critical region.
- Enhancing end-sealing performance by filling all gaps and surface defects at end pieces substrates

The invention also concerns an encapsulated actuator having a piezoelectric actuator stack and electrical connector means, wherein the stack is encapsulated in an encapsulation member, said encapsulation member comprises at least an innermost heat shrinkable, polymeric sleeve member and an overlaying outermost, heat shrinkable, polymeric sleeve member, the sleeve members having each a different shrinkage temperature, wherein the shrinkage temperature of the outermost sleeve member is higher than the shrinkage temperature of the innermost sleeve member.

The encapsulation member may, according to a preferred embodiment, further comprise a metallic film positioned around the innermost sleeve member.

Such a metallic film may be realized in different ways known to those skilled in the art. Some suitable examples are described in more detail in W02007093921. Aluminum and stainless steel are preferred for the metallic film.

The encapsulation member may further comprise at least one further heat shrinkable, polymeric sleeve member between the innermost and outermost sleeve members.

The piezoelectric actuator stack may be, in an alternative embodiment, a passivated piezoelectric actuator stack.

The difference between the shrinkage temperatures of the sleeve members is comprised preferably in the range of 5°C to 60°C. The difference between the shrinkage temperature of the sleeve members is preferably at least 10°, more preferably at least 20°C and most preferably at least 30°C. The difference between the shrinkage temperature of the sleeve members is, preferably at most 60°C, more preferably at most 50°C and most preferably at most 40°C.

### Brief Description of the Drawings

A preferred embodiment of the invention will now be described, by way of example, with reference to the accompanying drawings in which:

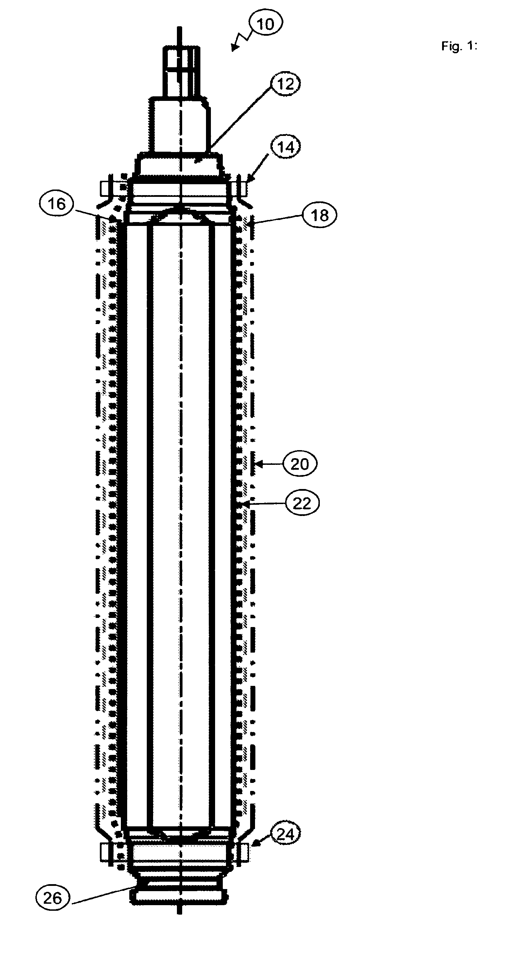

Figure 1 shows a schematic representation of a piezoelectric actuator

Referring to Figure 1, an encapsulated actuator arrangement, referred to generally as 10, comprises a stack of piezoelectric elements. The actuator arrangement is of the type suitable for use in a fuel injector for delivering fuel to an engine cylinder of an internal combustion engine. It comprises end pieces 12, 26 and end sealings 14, 24 at the top and bottom extremities of the actuator 10. The encapsulation of the actuator comprises a PZ ceramic passivation (a organic layer avoiding electrical short between Piezo ceramic layers) 16, a metallic film 18 and an outermost sleeve 20. The innermost sleeve 22 is sandwiched between the PZ ceramic passivation 16 and the metallic film 18. The innermost sleeve 22 is made of re-melted polymeric material and extends as well as the outermost sleeve 20 underneath the end sealings 14, 24. The fact that the innermost sleeve is molten under vacuum allows to fill any gaps.

Example of suitable materials are:
- Internal sleeve: ETFE LM 720 from Asahi Glass Company with a shrinkage temperature of 200°C and a melting temperature at 225°C,
- External HS: ETFE DAIKIN EP521 with a shrinkage temperature of 240°C a melting temperature at 260°C,
- Metallic film: laminated film with 20µm Al or 10µm stainless steel according AISI 304, 301, 316

The stack which is furnished with an insulating layer 16 is made from a polymer with a high dielectric strength, such as a polyimide (e.g. Kapton®), and acts as a passivating layer. The stack is then introduced inside a polymeric sleeve made for example of ETFE LM 720 and then heated to about 200°C for about 20 minutes so that the sleeve is shrunk. After cooling, the stack is then wrapped in a metal foil as discussed above and introduced in a second sleeve made for example of ETFE DAIKIN EP521. It is worthwhile to note that the second sleeve material has a higher shrinkage temperature and a higher melting temperature than the material used for the inner sleeve. The stack is then introduced inside an oven and a vacuum of about 10 millibar is created inside the oven. The parts are subsequently heated for about 60 minutes under vacuum at about 240°C so that the inner sleeve material melts and the outer sleeve material is shrunk. The atmospheric pressure is then re-established inside the oven and the parts are removed and cooled to ambient temperature.

### Legend:

- 10: actuator
- 12: actuator end piece
- 14: end sealing
- 16: pz ceramic passivation
- 18: metallic film
- 20: outermost sleeve innermost sleeve of re-melted
- 22: polymer
- 24: end sealing
- 26: end piece

## Claims

1. A method of encapsulating an actuator having a piezoelectric actuator stack and electrical connector means, wherein the stack is encapsulated in an encapsulation member, said encapsulation member comprising at least an innermost heat shrinkable, polymeric sleeve member and an overlaying outermost, heat shrinkable, polymeric sleeve member, the sleeve members having each a different shrinkage temperature, wherein the shrinkage temperature of the outermost sleeve member is higher than the shrinkage temperature of the innermost sleeve member, said method comprising the following steps:
a. arranging the stack inside the innermost sleeve member,
b. arranging the outermost sleeve member so as to overlay the innermost sleeve member,
c. placing the stack under vacuum so as to degas it,
d. heating the stack above the shrinkage temperature of the outermost sleeve member so as to shrink the outermost sleeve member,
e. placing the stack under atmospheric pressure
f. cooling the stack.

2. The method according to claim 1 wherein the method further comprises the following step between step a and step b:
a1) heating the stack above the shrinkage temperature of the innermost sleeve member so as to shrink said innermost sleeve member.

3. The method according to claim 1 or 2, wherein the sleeve members have a different melting temperature, the shrinkage temperature of the outermost sleeve member is higher than the melting temperature of the innermost sleeve member and wherein the innermost sleeve member is melted during step c.

4. The method according to any of the claims 1 to 3, wherein the method further comprises wrapping a metallic film around the innermost sleeve member between step a and b.

5. The method according to any of the claims 1 to 4, wherein the method further comprises arranging the stack inside one or more further sleeve members between step a and step b.

6. The method according to any of the claims 1 to 5, wherein the method further comprises end sealing the actuator.

7. The method according to any of the claims 1 to 6, wherein the method further comprises mechanically compressing the encapsulation member to shape it.

8. The method according to any of the claims 1 to 7, wherein the piezoelectric actuator stack is passivated before encapsulation.

9. An encapsulated actuator having a piezoelectric actuator stack and electrical connector means, wherein the stack is encapsulated in an encapsulation member wherein the encapsulation member comprises at least an innermost heat shrinkable, polymeric sleeve member and an overlaying outermost, heat shrinkable, polymeric sleeve member, the sleeve members having each a different shrinkage temperature, wherein the shrinkage temperature of the outermost sleeve member is higher than the shrinkage temperature of the innermost sleeve member.

10. The encapsulated actuator according to claim 9, wherein the encapsulation member further comprises a metallic film around the innermost sleeve member.

11. The encapsulated actuator according to claim 9 or 10, wherein the encapsulation member comprises at least one further heat shrinkable, polymeric sleeve member between the innermost and outermost sleeve members.

12. The encapsulated actuator according to any of the claims 9 to 11, wherein the piezoelectric actuator stack is a passivated piezoelectric actuator stack.

13. The encapsulated actuator according to any of the claims 9 to 12, wherein the difference between the shrinkage temperatures of the sleeve members is comprised in the range of 5 to 60°C.

14. The encapsulated actuator according to any of the claims 9 to 13, wherein the difference between the shrinkage temperatures of the sleeve members is preferably at least 10°, more preferably at least 20°C and most preferably at least 30°C.

15. The encapsulated actuator according to any of the claims 9 to 14, wherein the difference between the shrinkage temperatures of the sleeve members is, preferably at most 60°C, more preferably at most 50°C and most preferably at most 40°C.

## Patentansprüche

1. Verfahren zum Kapseln eines Aktors, der einen piezoelektrischen Aktorstapel und elektrische Verbindermittel hat, wobei der Stapel in einem Kapselungselement eingekapselt wird, wobei das genannte Kapselungselement wenigstens ein innerstes durch Wärme schrumpfbares polymeres Schlauchelement und ein überlagerndes äußerstes durch Wärme schrumpfbares polymeres Schlauchelement umfasst, wobei die Schlauchelemente jeweils verschiedene Schrumpftemperaturen haben, wobei die Schrumpftemperatur des äußersten Schlauchelements höher als die Schrumpftemperatur des innersten Schlauchelements ist, wobei das genannte Verfahren die folgenden Schritte aufweist:
a. Anordnen des Stapels in dem innersten Schlauchelement,
b. Anordnen des äußersten Schlauchelements, so dass es das innerste Schlauchelement überlagert,
c. Setzen des Stapels unter Unterdruck, um ihn zu entgasen,
d. Erwärmen des Stapels auf über die Schrumpftemperatur des äußersten Schlauchelements, um das äußerste Schlauchelement zu schrumpfen,
e. Setzen des Stapels unter atmosphärischen Druck,
f. Kühlen des Stapels.

2. Verfahren nach Anspruch 1, wobei das Verfahren ferner den folgenden Schritt zwischen Schritt a und Schritt b aufweist:
a1) Erwärmen des Stapels auf über die Schrumpftemperatur des innersten Schlauchelements, um das genannte innerste Schlauchelement zu schrumpfen.

3. Verfahren nach Anspruch 1 oder Anspruch 2, wobei die Schlauchelemente eine unterschiedliche Schmelztemperatur haben, die Schrumpftemperatur des äußersten Schlauchelements höher als die Schmelztemperatur des innersten Schlauchelements ist und wobei das innerste Schlauchelement während Schritt c geschmolzen wird.

4. Verfahren nach einem der Ansprüche 1 bis 3, wobei das Verfahren ferner das Umhüllen des innersten Schlauchelements zwischen Schritt a und b mit einer metallischen Folie aufweist.

5. Verfahren nach einem der Ansprüche 1 bis 4, wobei das Verfahren ferner das Anordnen des Stapels in einem oder mehreren weiteren Schlauchelementen zwischen Schritt a und Schritt b aufweist.

6. Verfahren nach einem der Ansprüche 1 bis 5, wobei das Verfahren ferner das Endverschließen des Aktors aufweist.

7. Verfahren nach einem der Ansprüche 1 bis 6, wobei das Verfahren ferner das mechanische Zusammendrücken des Kapselungselements, um es zu formen, aufweist.

8. Verfahren nach einem der Ansprüche 1 bis 7, wobei der piezoelektrische Aktor vor der Kapselung passiviert wird.

9. Gekapselter Aktor mit einem piezoelektrischen Aktorstapel und elektrischen Verbindermitteln, wobei der Stapel in einem Kapselungselement gekapselt ist, wobei das Kapselungselement wenigstens ein innerstes durch Wärme schrumpfbares polymeres Schlauchelement und ein überlagerndes äußerstes durch Wärme schrumpfbares polymeres Schlauchelement aufweist, wobei die Schlauchelemente jeweils verschiedene Schrumpftemperaturen haben, wobei die Schrumpftemperatur des äußersten Schlauchelements höher als die Schrumpftemperatur des innersten Schlauchelements ist.

10. Gekapselter Aktor nach Anspruch 9, wobei das Kapselungselement ferner eine metallische Folie um das innerste Schlauchelement aufweist.

11. Gekapselter Aktor nach Anspruch 9 oder 10, wobei das Kapselungselement wenigstens ein weiteres durch Wärme schrumpfbares polymeres Schlauchelement zwischen dem innersten und dem äußersten Schlauchelement aufweist.

12. Gekapselter Aktor nach einem der Ansprüche 9 bis 11, wobei der piezoelektrische Aktorstapel ein passivierter piezoelektrischer Aktorstapel ist.

13. Gekapselter Aktor nach einem der Ansprüche 9 bis 12, wobei der Unterschied zwischen den Schrumpftemperaturen der Schlauchelemente im Bereich von 5 bis 60°C enthalten ist.

14. Gekapselter Aktor nach einem der Ansprüche 9 bis 13, wobei der Unterschied zwischen den Schrumpftemperaturen der Schlauchelemente vorzugsweise wenigstens 10°C, bevorzugt wenigstens 20°C und am meisten bevorzugt wenigstens 30°C beträgt.

15. Gekapselter Aktor nach einem der Ansprüche 9 bis 14, wobei der Unterschied zwischen den Schrumpftemperaturen der Schlauchelemente vorzugsweise höchstens 60°C, bevorzugt höchstens 50°C und am meisten bevorzugt höchstens 40°C beträgt.

## Revendications

1. Procédé pour encapsuler un actionneur ayant un empilement actionneur piézo-électrique et des moyens formant connecteur électrique, dans lequel l'empilement est encapsulé dans un élément d'encapsulage, ledit élément d'encapsulage comprend au moins un élément tout à fait intérieur en forme de fourreau polymère thermorétractable, et un élément tout à fait extérieur en forme de fourreau polymère thermorétractable, les éléments en forme de fourreau ayant chacun une température de rétraction différente, de sorte que la température de rétraction de l'élément en forme de fourreau tout à fait extérieur est plus élevée que la température de rétraction de l'élément en forme de fourreau tout à fait intérieur, ledit procédé comprenant les étapes suivantes :
a) on agence l'empilement à l'intérieur de l'élément en forme de fourreau tout à fait intérieur,
b) on agence l'élément en forme de fourreau tout à fait extérieur de manière à recouvrir l'élément en forme de fourreau tout à fait intérieur,
c) on place empilement sous vide de manière à le dégazer,
d) on chauffe l'empilement au-dessus de la température de rétraction de l'élément en forme de fourreau tout à fait extérieur de manière à faire rétracter l'élément en forme de fourreau tout à fait extérieur,
e) on place empilement sous pression atmosphérique, et
f) on refroidit empilement.

2. Procédé selon la revendication 1, dans lequel le procédé comprend en outre l'étape suivante, entre l'étape a et l'étape b :
a1) on chauffe l'empilement au-dessus de la température de rétraction de l'élément en forme de fourreau tout à fait intérieur de manière à faire rétracter ledit élément en forme de fourreau tout à fait intérieur.

3. Procédé selon la revendication 1 ou 2, dans lequel les éléments en forme de fourreaux ont une température de fusion différente, la température de rétraction de l'élément en forme de fourreau tout à fait extérieur est plus élevée que la température de fusion de l'élément en forme de fourreau tout à fait intérieur, et dans lequel l'élément en forme de fourreau tout à fait intérieur est amené en fusion pendant l'étape c.

4. Procédé selon l'une quelconque des revendications 1 à 3, dans lequel le procédé comprend en outre d'envelopper un film métallique autour de l'élément en forme de fourreau tout à fait intérieur entre l'étape a et l'étape b.

5. Procédé selon l'une quelconque des revendications 1 à 4, dans lequel le procédé comprend en outre d'agencer l'empilement à l'intérieur d'un ou plusieurs autres éléments en forme de fourreaux entre l'étape a et l'étape b.

6. Procédé selon l'une quelconque des revendications 1 à 5, dans lequel le procédé comprend en outre de sceller l'actionneur à l'extrémité.

7. Procédé selon l'une quelconque des revendications 1 à 6, dans lequel le procédé comprend en outre de compresser mécaniquement l'élément d'encapsulage pour le mettre en forme.

8. Procédé selon l'une quelconque des revendications 1 à 7, dans lequel l'empilement actionneur piézo-électrique est passivé avant l'encapsulage.

9. Actionneur encapsulé ayant un empilement actionneur piézo-électrique et des moyens formant connecteur électrique, dans lequel l'empilement est encapsulé dans un élément d'encapsulage, l'élément d'encapsulage comprend au moins un élément en forme de fourreau polymère thermorétractable tout à fait intérieur, et un élément en forme de fourreau polymère thermorétractable tout à fait extérieur qui le recouvre, les éléments en forme de fourreau ayant chacun une température de rétraction différente, telles que la température de rétraction de l'élément en forme de fourreau tout à fait extérieur est plus élevée que la température de rétraction de l'élément en forme de fourreau tout à fait intérieur.

10. Actionneur encapsulé selon la revendication 9, dans lequel l'élément d'encapsulage comprend en outre un film métallique autour de l'élément en forme de fourreau tout à fait intérieur.

11. Actionneur encapsulé selon la revendication 9 ou 10, dans lequel l'élément d'encapsulage comprend au moins un autre élément en forme de fourreau polymère thermorétractable entre l'élément en forme de fourreau tout à fait intérieur et l'élément en forme de fourreau tout à fait extérieur.

12. Actionneur encapsulé selon l'une quelconque des revendications 9 à 11, dans lequel l'empilement actionneur piézo-électrique est un empilement actionneur piézo-électrique passivé.

13. Actionneur encapsulé selon l'une quelconque des revendications 9 à 12, dans lequel la différence entre les températures de rétraction des éléments en forme de fourreau est comprise dans la plage de 5 à 60° C.

14. Actionneur encapsulé selon l'une quelconque des revendications 9 à 13, dans lequel la différence entre les températures de rétraction des éléments en forme de fourreau est de préférence au moins 10°, de façon plus préférée au moins 20° C, et de la manière la plus préférée au moins 30° C.

15. Actionneur encapsulé selon l'une quelconque des revendications 9 à 14, dans lequel la différence entre les températures de rétraction des éléments en forme de fourreau est de préférence au plus 60° C, de façon plus préférée au plus 50° C, et de la manière la plus préférée au plus 40° C.
